# EUROPÄISCHE PATENTSCHRIFT

(11) **EP 3 953 318 B1**
(45) Veröffentlichungstag und Bekanntmachung des Hinweises auf die Patenterteilung: **26.03.2025**
(21) Anmeldenummer: 20718650.3
(22) Anmeldetag: 09.04.2020
(51) Int. Cl.: C06B 21/00, C23C 14/22, C23C 16/513

(54) **BESCHICHTUNGSVERFAHREN EINES ENERGETISCHEN MATERIALS**
COATING METHOD FOR ENERGETIC MATERIAL
PROCÉDÉ DE REVÊTEMENT D'UN MATÉRIAU ÉNERGÉTIQUE

(30) Priorität: 11.04.2019 DE 102019205276
(43) Veröffentlichungstag der Anmeldung: 16.02.2022
(73) Patentinhaber: Diener, Christof-Herbert, 72202 Nagold (DE)
(72) Erfinder: Diener, Christof-Herbert, 72202 Nagold (DE)
(74) Vertreter: Kohler Schmid Möbus Patentanwälte
(86) Internationale Anmeldenummer: PCT/EP2020/060242
(87) Internationale Veröffentlichungsnummer: WO 2020/208178

(56) Entgegenhaltungen:
- CN-A- 103 342 619
- DE-A1- 19 521 385
- US-A1- 2019 023 630
- US-B1- 10 125 058
- BRUCE CRANFORD: "Energetic Materials; What are they?", 20 November 2008 (2008-11-20), Energetic Materials Group Annual Meeting, American Institute of Chemical Engineers Annual Meeting, Philadelphia, Pa, XP055742984, Retrieved from the Internet <URL:http://folk.ntnu.no/skoge/prost/proceedings/aiche-2008/data/papers/P125072.pdf> [retrieved on 20201022]
- ANARAM SHAHRAVAN ET AL: "Passivation of Aluminum Nanoparticles by Plasma-Enhanced Chemical Vapor Deposition for Energetic Nanomaterials", ACS APPLIED MATERIALS & INTERFACES, vol. 6, no. 10, 7 May 2014 (2014-05-07), US, pages 7942 - 7947, XP055715185, ISSN: 1944-8244, DOI: 10.1021/am5012707

## Beschreibung

### Technisches Gebiet

Die Erfindung betrifft ein Beschichtungsverfahren eines energetischen Materials, das in Form von Körnern, Pellets und/oder als Pulver ausgebildet ist, mit einem Beschichtungsmaterial.

### Stand der Technik

Es ist aus dem Stand der Technik bekannt, dass die Verbrennungseigenschaften von energetischen Materialien durch geeignete Beschichtungen der energetischen Materialien beeinflusst werden. Beschichtungen können unter anderem die Druck-Zeit-Kurve des Brennprozesses verändern. Außerdem können Beschichtungen die Haltbarkeit der energetischen Materialien während der Lagerung und die Reproduzierbarkeit der Explosionsstärke erhöhen. In anderen Fällen vereinfachen Beschichtungen der energetischen Materialien die Fertigungsprozesse oder reduzieren das Unfallrisiko.

In der CA939967A wird die Brennrate von Körnern von Treibladungen mit Hilfe von Lösungen umfassend Polyvinylacetat oder Kunststoffe, die N-Butylmethacrylat oder Methylzellulose aufweisen, verändert. Eine den Brennprozess verzögernde Beschichtung auf der Grundlage von Polyisocyanat ist in der IL47494A angeführt. In der US6345577B1 ist eine den Brennprozess verlangsamende Beschichtung offenbart, die unter anderem Dihydrozinotetrazene aufweist. Graphitbeschichtungen für Schießpulver sind in Bailey and Murray (Explosives, Propellants and Pyrotechnics, London, 1989, 94) genannt. Die Graphitbeschichtungen schützen das Schießpulver vor Feuchtigkeit und dienen als Schmiermittel beim Befüllen von Patronen. Außerdem bilden die Beschichtungen einen elektrischen Leiter, um die Ansammlung elektrischer Ladungen zu verhindern. Weitere Beschichtungen für Schießpulver als Schmiermittel sind in der US5970877A offenbart. Dabei wird das üblicherweise zur Beschichtung verwendete Graphit zumindest teilweise durch Molybdänsulfid in einer Menge von bis zu 0,5 Gewichtsprozent des Schießpulvers ersetzt.

Aus der CN 103 342 619 B ist ein Beschichtungsverfahren für explosive Partikel bekannt geworden, bei dem die explosiven Partikel zunächst mit Wachs und anschließend mit einem Parylen-Film beschichtet werden.

Die Beschichtung von Aluminium-Nanopartikeln ist aus ACS Applied materials and interfaces, Bd. 6, Nr. 10, 7. Mai 2014, Seiten 7942-7947 bekannt geworden.

Die DE 195 21 385 A1 offenbart ein Verfahren zum elektrischen Zünden und Steuern des Verbrennens einer Treibladung.

Aus der US 10 125 058 B1 ist die Zusammensetzung explosiver Partikel bekannt geworden. Die explosiven Partikel sind sputterbeschichtet.

Die US 2019/023630 A1 offenbart weitere Materialien und Verfahren zur Herstellung maßgeschneiderter reaktiver Komponenten.

Schließlich werden die Eigenschaften energetischer Materialien in dem Artikel "Energetic Materials; What are they?" von Bruce Cranford; XP055742984; 20. November 2008; Energetic Materials Group Annual Meeting, American Institute of Chemical Engineers Annual Meeting, Philadelphia, Pa, diskutiert.

Die vorgenannten Beschichtungsverfahren beziehen sich jeweils auf spezifische Beschichtungsmaterialien.

Es ist demgegenüber Aufgabe der Erfindung, ein Beschichtungsverfahren bereitzustellen, durch das unterschiedliche Arten von Beschichtungsmaterialien in kurzer Zeit auf die gesamte Oberfläche des jeweiligen energetischen Materials verteilt werden können.

Die Aufgabe wird durch ein Beschichtungsverfahren gemäß Anspruch 1 gelöst. Vorteilhafte Ausgestaltungen ergeben sich aus den rückbezogenen Unteransprüchen.

### Offenbarung der Erfindung

Das erfindungsgemäße Beschichtungsverfahren betrifft die Beschichtung eines energetischen Materials, das in Form von Körnern, Pellets und/oder als Pulver ausgebildet ist, mit einem Beschichtungsmaterial. Das Beschichtungsverfahren ist dadurch gekennzeichnet, dass das Beschichtungsmaterial
a) hydrophob oder hydrophil und/oder
b) elektrisch leitfähig ist.

Durch die Beschichtung lassen sich die Eigenschaften des Beschichtungsmaterials auf das energetische Material bzw. die Oberfläche des energetischen Materials übertragen. Das Beschichtungsverfahren ist vorzugsweise als Dünnschicht-Beschichtungsverfahren ausgebildet. Das Beschichtungsmaterial ist insbesondere feuchtigkeitsabweisend, chemisch träge, antistatisch, korrosionsschützend. Das Beschichtungsmaterial kann elektrisch leitfähig ausgebildet sein, wenn es zum Beispiel Poly-3,4-ethylendioxythiophen (PEDOT) aufweist. Zum Schutz gegen Korrosion kann das Beschichtungsmaterial unter anderem Plasmapolymere, Paraffin, Nickel und/oder Parylene aufweisen. Durch die Beschichtung mit dem erfindungsgemäßen Beschichtungsverfahren kann der Ausstoß von Stickstoffoxiden verringert werden. Im Rahmen des Beschichtungsverfahrens lassen sich Beschichtungen des energetischen Materials herstellen, die Harnstoffe und ähnlich wirkende Verbindungen aufweisen, unter anderem wenn die Beschichtung mit einem Plasma durchgeführt wird, das Ammoniak (NH₃) und Kohlenstoffdioxid (CO₂) aufweist. Dadurch lassen sich Schützen, die ein derartig beschichtetes energetisches Material verwenden, und Waffen, in denen sich ein derartig beschichtetes energetisches Material befindet, vor salpetriger Säure und somit im Fall von Waffen vor Korrosion schützen.

Das Beschichtungsmaterial kann versiegelnd, isolierend und/oder resistent gegen Lösungsmittel ausgebildet sein. Durch Beschichtung von energetischen Materialien läßt sich Mündungsfeuer vergrößern, verkleinern und/oder einstellen. Die Beschichtungen und/oder Modifikationen können als Markierungsmittel ausgebildet sein. Eine Markierung in Form eines Beschichtungsmittels dient dem Plagiatsschutz und/oder als Antiterrormittel. Das Beschichtungsmaterial kann das Abbrandverhalten und/oder die Brennrate des energetischen Materials modifizieren. Das Beschichtungsmaterial kann als Schmiermittel ausgebildet sein, insbesondere für Geschosse und Hülsen. Das Beschichtungsmaterial kann die Oberfläche des energetischen Materials chemisch modifizieren. Die Oberfläche eines energetischen Materials kann durch die Beschichtung funktionalisiert werden. Die Beschichtung kann hierbei nur eine Atomlage dick sein.

Erfindungsgemäß erfolgt die Beschichtung durch eine chemische Gasphasenabscheidung (CVD) im Vakuum. Dass die Beschichtung im Vakuum erfolgt, bedeutet insbesondere, dass in der Vakuumkammer, in der die Beschichtung stattfindet, ein Druck von weniger als einem Bar, insbesondere von weniger als einem Millibar, vorliegt. Durch solche Beschichtungsverfahren können unterschiedliche Arten von Beschichtungsmaterialien in kurzer Zeit auf die gesamte Oberfläche des vorhandenen energetischen Materials bzw. der Bestandteile des energetischen Materials, wie zum Beispiel Körner oder Pellets, verteilt werden. Durch das Vakuum wird ein zusätzlicher Trocknungseffekt bewirkt, was insbesondere bei der Beschichtung von Schießpulver vorteilhaft ist.

Die Beschichtung in dem Beschichtungsverfahren kann durch Massenkleineteilebeschichtung in einer Massenkleineteilebeschichtungsanlage erfolgen.

Energetische Materialien wie Treibladungen und explosive Pulver, Körner oder Pellets werden unter anderem in Waffensystemen, in militärischen und zivilen pyrotechnischen Vorrichtungen, für Feuerwerke, für Rettungssignale, Gasgeneratoren, insbesondere Gasgeneratoren für Airbags, für industrielle, mit Explosionen verbundene Prozesse oder für Abrisse verwendet. Wenn sie nicht ordnungsgemäß gelagert oder verwendet werden, kann ein Großteil dieser energetischen Materialien Luftfeuchtigkeit, Wasser, absorbieren, wodurch sie nutzlos werden. Andere energetische Materialien, wie einige heterogene pyrotechnische Mischungen und Pulver, verfallen (zum Beispiel durch die Reaktion von Magnesium mit Luftfeuchtigkeit, wobei Wasserstoff freigesetzt wird) oder sie zünden unter ungünstigen Umständen und verursachen so schwerwiegende Unfälle. Dies betrifft zum Beispiel Schwarzpulver (eine Mischung von Kaliumnitrat, Schwefel und Holzkohle in Form von Körnern), pyrotechnische Pellets, die Metall enthalten, rauchschwache Pulver und andere Sprengstoffe, insbesondere hygroskopische Sprengstoffe, in Form von Pulvern oder Körnern.

Daher stellen geeignete Beschichtungen von Treibladungen, Sprengstoffen und pyrotechnischen Körnern potentielle Lösungen für verschiedene Aufgaben dar, unter anderem: Methoden zur Hydrophobierung, Hydrophilisierung, zur Entfernung von elektrischen Ladungen, zur Schmierung von Oberflächen von Sprengmitteln, zum Beispiel zum Befüllen von Munitionskisten oder zur Markierung gegen terroristische Verwendung.

Ein weiteres Problem in Bezug auf Treibladungen für Waffen und Raketenantriebe stellt die Kontrolle der Brennrate dar. Durch geeignete hemmende Oberflächenbeschichtungen kann die Geschwindigkeit des Verbrennungsprozesses vermindert werden, zum Beispiel indem die Treibladung durch die Oberflächenbeschichtung schrittweise verbrennt. Dies betrifft rauchschwache Pulver in allen Varianten und Formen wie Zylinderform und Kugelform ebenso wie Schwarzpulver und pyrotechnische Körner und Pellets.

Die Komponenten energetischer Materialien weisen insbesondere Oxidationsmittel, unter anderem Ammoniumnitrat, Strontiumnitrat, Bariumnitrat, und/oder Reduktionsmittel, unter anderem Schwefel, Kohlenstoff, Metallpulver, insbesondere mit Aluminium, Magnesium, Titan, auf.

Durch das erfindungsgemäße Beschichtungsverfahren im Vakuum wird die Oberfläche von Treibladungen und Explosivstoffen in Form von Pulver, Körnern und Pellets mit einer Beschichtung beschichtet, deren Dicke 0,1 Nanometer oder mehr beträgt. Die Beschichtung ist insbesondere chemisch inert, hydrophob, hydrophil und/oder elektrisch leitfähig. Die Beschichtung kann als Schmiermittel oder als Markierung verwendet werden. Zusätzlich oder alternativ dazu wird die Oberfläche des energetischen Materials chemisch modifiziert.

Hydrophobe Beschichtungen stoßen Feuchtigkeit in der Luft ab und verhindern unerwünschte Änderungen der physikalischen Eigenschaften, insbesondere des Brenn- und Explosionsverhaltens von Treibladungen eines pyrotechnischen Satzes oder Sprengstoffen. Insbesondere können sich im Fall von Pellets aus Schwarzpulver Wasserkontaktwinkel durch eine Beschichtung unter Verwendung von Plasma von 20° auf 120° ändern. Außerdem lässt sich die Brennrate von Sprengstoffen durch die Beschichtungen beeinflussen.

Durch hydrophile Beschichtungen lässt sich andererseits die Benetzbarkeit hydrophober Sprengstoffe erhöhen und die Herstellung von explosiven Materialien in Form von Schlämmen, Suspensionen und/oder wässrigen Gelen ermöglichen. Der Wasserkontaktwinkel lässt sich, insbesondere bei Trinitrotoluol (TNT), durch Beschichtungsverfahren mit Plasma von 94,5° auf weniger als 20° verändern.

Insbesondere Perfluoracrylate (unter anderem PFAC6, PFAC8) als Beschichtungsmaterial weisen stark hydrophobe Eigenschaften auf. Energetisches Material, insbesondere Schwarzpulver, das mit einem Perfluoracrylat, z.B.PFAC8, als Beschichtungsmaterial nach dem erfindungsgemäßen Beschichtungsverfahren beschichtet wird, ist auch 24 Stunden nach dem Kontakt mit Wasser weitestgehend trocken.

Die Beschichtungsmaterialien können Schutzschichten aufweisen, die Nickel, Chrom, Mangan umfassen.

Die Beschichtungsmaterialien weisen insbesondere zumindest eine Chemikalie zur Hydrophobierung auf, vorzugsweise mit zumindest einer CH₃-Gruppe und/oder einer CF₃-Gruppe.

Im Fall von energetischen Materialien in Form von Körnern ist ein wichtiger Faktor, der die Verbrennungsrate von energetischen Materialien mitbestimmt, der Flächeninhalt der brennbaren Oberfläche dieser Körner. Der Brennprozess der Körner lässt sich kontrollieren, indem die brennbare Oberfläche ganz oder teilweise mit einem den Brennprozess verzögernden Beschichtungsmaterial beschichtet wird.

Eine Ausführungsform des Beschichtungsverfahrens ist dadurch gekennzeichnet, dass das energetische Material einen Sprengstoff, einen pyrotechnischen Satz und/oder eine Treibladung aufweist. Dabei werden im Rahmen der Anmeldung unter Sprengstoffen insbesondere Stoffe verstanden, die unter Ablauf einer chemischen Reaktion Energie in Form einer Druckwelle freisetzen. Ein pyrotechnischer Satz weist insbesondere ein Oxidationsmittel und einen Brennstoff auf. Das Beschichtungsverfahren kann auch zur Beschichtung von Zündschnüren und/oder pyrotechnischen Vorrichtungen verwendet werden.

Eine Ausgestaltung des Beschichtungsverfahrens ist dadurch gekennzeichnet, dass das energetische Material eine Explosionswärme von mehr als 2500 kJ/kg und/oder eine Abbrandgeschwindigkeit von mehr als 30 m/s und/oder eine Bleiblockausbauchung von mehr als 30 cm³ aufweist. Insbesondere weist das energetische Material eine Explosionswärme von 2500 kJ/kg bis 7000 kJ/kg und/oder eine Abbrandgeschwindigkeit von 50 m/s bis 8000 m/s, vorzugsweise eine Abbrandgeschwindigkeit von 2000 m/s bis 5000 m/s, und/oder eine Bleiblockausbauchung von 300 cm³ bis 550 cm³ auf.

Eine weitere Ausführungsform des Beschichtungsverfahrens ist dadurch gekennzeichnet, dass das energetische Material Schwarzpulver, rauchschwache Pulver, Nitroglycerin und/oder Nitrozellulose aufweist. Insbesondere weist das energetische Material Pikrinsäure, Hydrazin, Trinitrotoluol (TNT), Glykoldinitrat, Nitropenta und/oder Initialsprengstoff auf.

Eine Ausbildung des Beschichtungsverfahrens ist dadurch gekennzeichnet, dass das Beschichtungsmaterial Halogene; Monomere, die zumindest ein Halogen aufweisen; Silizium; Monomere, die Silizium aufweisen; Silazane, insbesondere Hexamethyldisilazan; Siloxane; Silane; Fluor; Kohlenwasserstoff; insbesondere gesättigten und/oder ungesättigten Kohlenwasserstoff; aliphatischen Kohlenwasserstoff; aromatischen Kohlenwasserstoff; Derivate von aliphatischem Kohlenwasserstoff und/oder aromatischem Kohlenwasserstoff, die insbesondere Heteroatome aufweisen; Sauerstoff; leitfähige Polymere; Alkane, insbesondere Fluoralkane; Cycloalkane; Mischungen umfassend Alkane und Halogene; Alkene, Mischungen umfassend Alkene und Halogene; Hexamethyldisiloxan; Fluoracrylate; Octafluorcyclobutan; Ethin; Parylene; Paraffin; Octen; Hexafluorethan; Perfluoracrylat; Acrylsäure und/oder Kombinationen der vorgenannten Stoffe aufweist.

Eine vorteilhafte Ausgestaltung des Beschichtungsverfahrens ist dadurch gekennzeichnet, dass die Beschichtung bei einem Druck von maximal 10 Millibar und/oder einer Temperatur von maximal 130° Celsius erfolgt. In einem solchen Temperaturbereich und einem solchen Druckbereich lassen sich die Gasphasenabscheidungsverfahren zur Beschichtung der energetischen Materialien besonders effizient durchführen.

Die Beschichtung erfolgt durch eine plasmaunterstützte chemische Gasphasenabscheidung. Mit der plasmaunterstützten chemischen Gasphasenabscheidung (PECVD) lassen sich auch temperaturempfindliche energetische Materialien beschichten. Insbesondere kann Atmosphärendruckplasma zur Beschichtung verwendet werden. Vorzugsweise wird eine Plasmapolymerisation als Ausgestaltung des Beschichtungsverfahrens verwendet.

Die Beschichtung des jeweiligen energetischen Materials erfolgt in einer Vakuumkammer, die während der Gasphasenabscheidung um eine in horizontaler Richtung verlaufende Drehachse gedreht wird. Das energetische Material, insbesondere Körner des energetischen Materials, wird in vertikaler Richtung aufwärts und abwärts bewegt. Das energetische Material verteilt sich in der Vakuumkammer. Dadurch kann das energetische Material, bzw. Körner des energetischen Materials, an der gesamten Oberfläche beschichtet werden.

Vorteilhaft erfolgt die Zündung des Plasmas durch eine Elektrode in der Vakuumkammer, die insbesondere mit einem elektrischen Isolator, vorzugsweise Glas oder Keramik, beschichtet ist. Durch den Isolator werden unter anderem Spannungsdurchschläge zwischen der Elektrode und ihrer Umgebung verhindert.

Eine weitere Ausgestaltung des Beschichtungsverfahrens ist dadurch gekennzeichnet, dass die Beschichtung mit einer Dicke von mehr als 0,1 Nanometer, insbesondere einer Dicke von mehr als 10 Nanometern und besonders einer Dicke von maximal zwei Mikrometern aufgetragen wird. Die Dicke kann zwischen 0,1 Nanometer und 10 Nanometern, insbesondere 1 Nanometer und 5 Nanometern liegen. Vorzugsweise wird die Beschichtung mit einer Dicke von 100 Nanometer bis 1,5 Mikrometer, besonders bevorzugt mit einer Dicke von 700 Nanometer bis einem Mikrometer aufgetragen.

Eine Beschichtungsanlage zur Beschichtung eines energetischen Materials nach einer der vorgenannten Ausführungsformen weist eine Vakuumkammer auf, die einen Einlass für Gas aufweist. Die Beschichtungsanlage ist dadurch gekennzeichnet, dass die Kammer durch eine an der Kammer angeordnete und in horizontaler Richtung verlaufende Welle drehbar ist und sich in der Kammer beschichtetes energetisches Material befindet. Bei einer solchen Beschichtungsanlage verteilt sich das energetische Material während des Beschichtungsverfahrens durch eine vertikale Aufwärts- und Abwärtsbewegung in der Vakuumkammer. Dadurch kann das energetische Material an der gesamten Oberfläche beschichtet werden, bzw. Körner des energetischen Materials an deren jeweiliger gesamter Oberfläche beschichtet werden. Durch die Rotation der Vakuumkammer findet eine Umwälzbewegung des energetischen Materials statt. Das Beschichtungsmaterial verteilt sich um die Körner des energetischen Materials. Es bilden sich Wirbelschichten des energetischen Materials aus. Durch die Verwendung eines abgeschlossenen Gefäßes für das Beschichtungsverfahren, hier in Form der Vakuumkammer, wird verhindert, dass sich das energetische Material über eine unkontrolliert große Fläche verteilt.

Eine Weiterbildung der Beschichtungsanlage ist dadurch gekennzeichnet, dass die Kammer eine mit einem elektrisch isolierenden Material, insbesondere Glas oder Keramik, beschichtete Elektrode aufweist. Durch das isolierende Material werden unter anderem Spannungsdurchschläge zwischen der Elektrode und ihrer Umgebung verhindert.

Energetisches Material mit einer Beschichtung, die nach dem erfindungsgemäßen Beschichtungsverfahren aufgetragen ist, ist dadurch gekennzeichnet, dass die Beschichtung Halogene; Monomere, die zumindest ein Halogen aufweisen; Silizium; Monomere, die Silizium aufweisen; Silazane, insbesondere Hexamethyldisilazan; Siloxane; Silane; Fluor; Kohlenwasserstoff; insbesondere gesättigten und/oder ungesättigten Kohlenwasserstoff; aliphatischen Kohlenwasserstoff; aromatischen Kohlenwasserstoff; Derivate von aliphatischem Kohlenwasserstoff und/oder aromatischem Kohlenwasserstoff, die insbesondere Heteroatome aufweisen; Sauerstoff; leitfähige Polymere; Alkane, insbesondere Fluoralkane; Cycloalkane; Mischungen umfassend Alkane und Halogene; Alkene, Mischungen umfassend Alkene und Halogene; Hexamethyldisiloxan; Fluoracrylate; Octafluorcyclobutan; Ethin; Parylene; Paraffin; Octen; Hexafluorethan; Acrylsäure und/oder Kombinationen der vorgenannten Stoffe aufweist.

Eine Ausführungsform des energetischen Materials ist dadurch gekennzeichnet, dass das energetische Material Körner in einer Größe von mehr als 0,01 Millimetern, insbesondere einer Größe von maximal 1 Meter aufweist. Die Größe der Körner kann in anderen Ausführungsformen mehr als 1 Meter betragen. Der Begriff "Größe" bezieht sich insbesondere auf den Durchmesser, hier der Körner. Vorzugsweise weist das energetische Material Körner in einer Größe von 1 Millimeter bis 50 Zentimeter, besonders bevorzugt 5 Millimeter bis 5 Zentimeter auf.

Eine weitere Ausgestaltung des energetischen Materials ist dadurch gekennzeichnet, dass die Beschichtung eine Dicke von mehr als 0,1 Nanometer, insbesondere eine Dicke von mehr als 10 Nanometern und besonders eine Dicke von maximal zwei Mikrometern aufweist. Die Dicke kann zwischen 0,1 Nanometer und 10 Nanometern, insbesondere 1 Nanometer und 5 Nanometern liegen. Vorzugsweise ist die Beschichtung in einer Dicke von 500 Nanometer bis 1,5 Mikrometer, besonders bevorzugt mit einer Dicke von 700 Nanometer bis einem Mikrometer aufgetragen. Beschichtungen und/oder Modifikationen können flüssigkeitsabweisend bzw. hydrophob ausgebildet sein. Die Beschichtungen und/oder Modifikationen können derart ausgebildet sein, dass sie die Brennrate der energetischen Materialien verändern. Die Beschichtungen und/oder Modifikationen können elektrisch leitfähig und/oder antistatisch ausgebildet sein. Die Beschichtungen und/oder Modifikationen können als Schmiermittel ausgebildet sein. Die Beschichtungen und/oder Modifikationen können die Benetzungsfähigkeit der energetischen Materialien erhöhen, insbesondere in Bezug auf Wasser und organische Lösungsmittel. Die Beschichtungen und/oder Modifikationen können versiegelnd, isolierend und/oder resistent gegen Lösungsmittel ausgebildet sein. Die Beschichtungen und/oder Modifikationen können als Markierungsmittel ausgebildet sein. Die Beschichtungen und/oder Modifikationen werden in einer plasmaunterstützten chemischen Gasphasenabscheidung, zum Beispiel unter Verwendung von Parylenen, ausgebildet, insbesondere bei einem Druck, der kleiner als der atmosphärische Druck oder gleich dem atmosphärischen Druck ist. Insbesondere kann Spray auf Fluorbasis oder Silikonbasis zur Beschichtung verwendet werden, unter anderem Schuhspray. Die Beschichtungen und/oder Modifikationen können in einem rotierenden Behälter, einem mit Flüssigkeit gefüllten Behälter, unter Fallbewegungen von Körnern des energetischen Materials oder durch mechanisches Mischen ausgebildet werden. Die Beschichtungen und/oder Modifikationen können unter Verwendung eines Beschichtungsmaterials ausgebildet werden, wobei das Beschichtungsmaterial Monomere, die zumindest ein Halogen aufweisen, Silizium, Monomere, die Silizium aufweisen, Siloxane, Silazane, Silane, Fluor oder Kohlenwasserstoff, insbesondere gesättigten und/oder ungesättigten Kohlenwasserstoff, aliphatischen Kohlenwasserstoff, aromatischen Kohlenwasserstoff, Derivate von aliphatischem Kohlenwasserstoff und/oder aromatischem Kohlenwasserstoff, die insbesondere Heteroatome aufweisen, Sauerstoff, leitfähige Polymere, Alkane, insbesondere Fluoralkane, Cycloalkane, Mischungen umfassend Alkane und Halogene, Alkene, Mischungen umfassend Alkene und Halogene, Hexamethyldisiloxan, Fluoracrylate, Octafluorcyclobutan, Ethin, Parylene, Paraffin, Octen und/oder Hexafluorethan, leitfähige Polymere, Acrylsäure oder Kombinationen der vorgenannten Stoffe aufweist.

### Kurze Beschreibung der Zeichnung

Weitere Merkmale und Vorteile der Erfindung ergeben sich aus der nachfolgenden detaillierten Beschreibung mehrerer Ausführungsbeispiele der Erfindung, aus den Patentansprüchen sowie anhand der Figuren der Zeichnung, die erfindungswesentliche Einzelheiten zeigen.

Die in der Zeichnung gezeigten Merkmale sind derart dargestellt, dass die erfindungsgemäßen Besonderheiten deutlich sichtbar gemacht werden können.

In der Zeichnung zeigen:
- Fig. 1: eine Beschichtungsanlage zur Beschichtung eines energetischen Materials;
- Fig. 2: eine Paryleneanlage zur Beschichtung eines energetischen Materials.

### Ausführungsformen der Erfindung

In einer ersten Ausführungsform der Erfindung wurde als hygroskopische Treibladung ein Schwarzpulver in Form von Pellets gewählt. Vor der Beschichtung weist ein Wassertropfen von einem Mikroliter reinen Wassers fünf Sekunden nach der Anordnung auf der Oberfläche des Pellets einen Wasserkontaktwinkel von 23,2° auf. Der Wassertropfen wird in 15 Sekunden vollständig absorbiert.

Nach einer zehnminütigen Beschichtung mit Hexamethyldisiloxan weist ein Wassertropfen von einem Mikroliter reinen Wassers fünf Sekunden nach der Anordnung auf der Oberfläche des Pellets einen Wasserkontaktwinkel von 118,4° auf. Vier Minuten nach der Anordnung beträgt der Wasserkontaktwinkel 105,7°.

In einer zweiten Ausführungsform der Erfindung wird Schwarzpulver in Form von Pellets 10 Minuten mit 1-Okten beschichtet. Ein Wassertropfen von einem Mikroliter reinen Wassers weist fünf Sekunden nach der Anordnung auf der Oberfläche des Pellets einen Wasserkontaktwinkel von 122,7° auf. Vier Minuten nach der Anordnung beträgt der Wasserkontaktwinkel 91,2°.

Bei einer dritten Ausführungsform der Erfindung wird Schwarzpulver in Form von Pellets 20 Minuten mit Perfluoracrylat (PFAC 8) beschichtet. Ein Wassertropfen von einem Mikroliter reinen Wassers weist fünf Sekunden nach der Anordnung auf der Oberfläche des Pellets einen fast superhydrophobischen Wasserkontaktwinkel von 135,5° auf. Vier Minuten nach der Anordnung beträgt der Wasserkontaktwinkel 111,0°.

Bei einer vierten Ausführungsform der Erfindung wird eine Treibladung mit Nitrozellulose in rauchschwachem Pulver in einer 9x19 mm Patrone zweimal jeweils 20 Minuten mit Hexamethyldisiloxan beschichtet.

Bei einer fünften Ausführungsform der Erfindung wird eine Treibladung mit Nitrozellulose in rauchschwachem Puler in einer 9x19 mm Patrone zweimal jeweils 20 Minuten mit 1-Okten beschichtet.

Bei einer sechsten Ausführungsform der Erfindung wird eine Treibladung mit Nitrozellulose in rauchschwachem Puler in einer 9x19 mm Patrone zweimal jeweils 20 Minuten mit Perfluoromonomer 8 bzw. Perfluoracrylat 8 (PFAC 8) beschichtet.

Bei einer siebten Ausführungsform der Erfindung wird eine Treibladung mit Nitrozellulose in rauchschwachem Puler in einer 9x19 mm Patrone zweimal jeweils 20 Minuten mit Stickstoff-Trifluorid (NF₃) beschichtet.

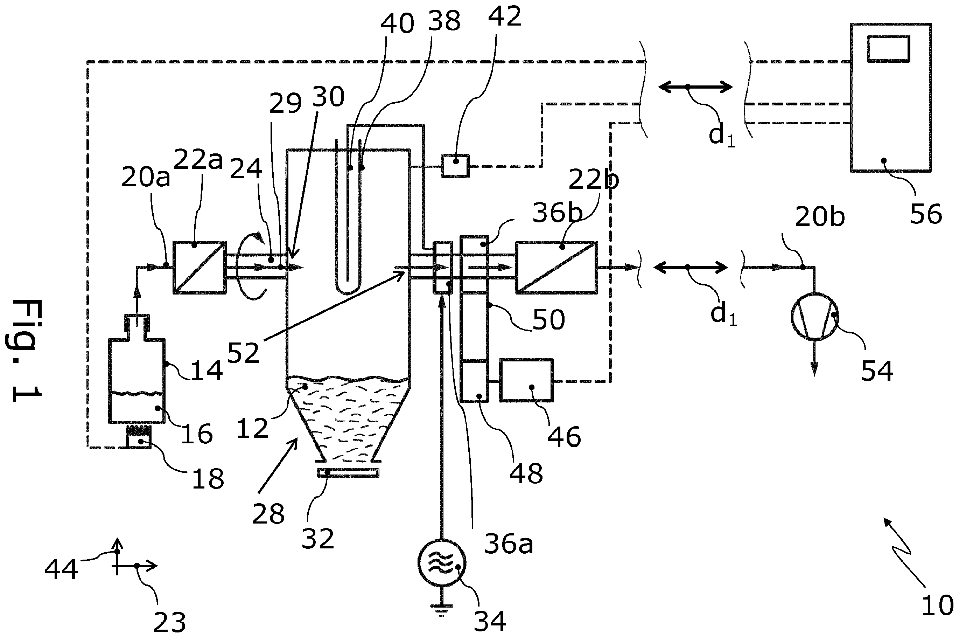

In **Fig. 1** ist eine Beschichtungsanlage **10** zur Beschichtung eines energetischen Materials **12** dargestellt. Die Beschichtungsanlage 10 weist einen Gasbehälter **14** auf, in dem sich ein Beschichtungsmaterial **16** befindet, das insbesondere durch einen Heizkörper **18** außerhalb des Gasbehälters 14 zu einem Beschichtungsgas verdampft wird. Eine erste fluidische Verbindung **20a** führt von dem Gasbehälter 14 zu einer fluidisch leitenden ersten Vakuumdrehdurchführung **22a.** Die erste Vakuumdrehdurchführung 22a umgreift eine Welle **24,** die um eine in horizontaler Richtung **23** verlaufende Drehachse drehbar ist. Die Welle 24 ist an gegenüberliegenden Seiten einer Vakuumkammer **28** befestigt, die durch die Welle 24 rotiert werden kann. Das Beschichtungsgas strömt in Form eines Gasflusses **29** durch die fluidisch leitende Welle 24 und tritt durch einen Beschichtungsgaseingang **30** in die Vakuumkammer 28 ein.

Die Vakuumkammer 28 ist durch einen Deckel **32** verschlossen. In der Vakuumkammer 28 befindet sich das energetische Material 12, das beschichtet werden soll, zum Beispiel Schwarzpulver, sowie Plasma (nicht gezeigt). Zur Erzeugung des Plasmas ist eine Spannungsquelle als Plasmagenerator **34** über einen ersten Schleifring **36a** an der Welle 24 mit einer Elektrode **40** in der Vakuumkammer 28 verbunden, die mit einer isolierenden Schicht **38,** hier in Form von Keramik, beschichtet ist. Ein Druckmessgerät **42** misst den Druck in der Vakuumkammer 28.

Durch das Plasma werden die Moleküle des Beschichtungsgases dissoziiert. Das energetische Material 12 wird mit Komponenten des dissoziierten Beschichtungsgases beschichtet. Durch die Rotation der Vakuumkammer 28 mit der horizontal verlaufenden Welle 24 wird das energetische Material 12 in der Vakuumkammer 28 in vertikaler Richtung **44** aufwärts und abwärts bewegt. Dabei liegt das energetische Material 12 insbesondere in Form von Körnern vor. Durch die Bewegung der Körner in vertikaler Richtung 44 sammeln sich die Körner nicht für lange Zeit an einem Ort ("am Boden" der Vakuumkammer) und können alle beschichtet werden.

Die Welle 24 wird durch einen Motor **46** gedreht, der mit einem Zahnrad **48** verbunden ist. Das Zahnrad 48 überträgt die Drehbewegung des Motors 46 durch eine Kette **50** auf einen zweiten Schleifring **36b,** der die Welle 24 umgreift.

Die restlichen Komponenten des Beschichtungsgases, die bei der Beschichtung nicht verwendet werden, strömen durch einen Beschichtungsgasausgang **52,** der dem Beschichtungsgaseingang 30 gegenüberliegt. Dann strömt das Beschichtungsgas durch eine zweite Vakuumdrehdurchführung **22b.** Anschließend treten die restlichen Komponenten des Beschichtungsgases durch eine zweite fluidische Verbindung **20b** und eine Vakuumpumpe **54** aus der Beschichtungsanlage 10 aus. Die Beschichtungsanlage 10 wird durch eine Steuerung **56** gesteuert. Dabei befinden sich die Vakuumpumpe 54 und die Steuerung 56 vorzugsweise in einem Abstand d₁ von mehr als 1 Meter, vorzugsweise mehr als drei Metern, von den übrigen Bestandteilen der Beschichtungsanlage 10.

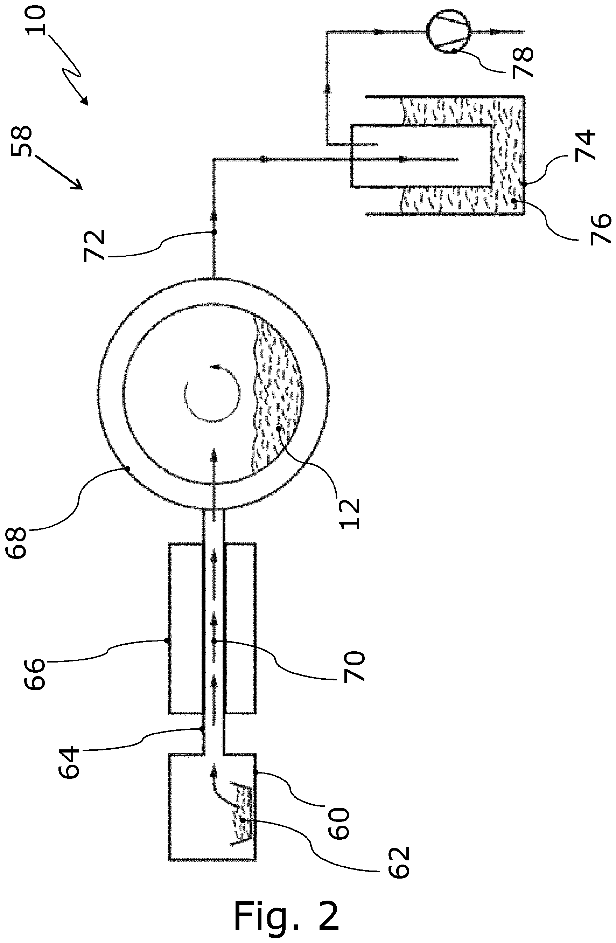

In **Fig. 2** ist als Beschichtungsanlage 10 eine Paryleneanlage **58** zur Beschichtung eines energetischen Materials **12** dargestellt. Die Paryleneanlage 58 weist einen Paryleneverdampfer **60** zum Verdampfen von Parylenen **62** bei etwa 250°C auf. Eine rohrförmige fluidische Verbindung **64** führt von dem Paryleneverdampfer 60 durch ein Pyrolyserohr **66** zu einer Drehtrommel **68.** Die Parylene treten als Parylene-Gasfluss **70** aus dem Paryleneverdampfer 60 aus und fließen durch das Pyrolyserohr 66, das insbesondere als Widerstandsheizung ausgebildet ist, hindurch. Beim Hindurchströmen durch das Pyrolyserohr 66 werden die Parylene bei etwa 650°C in Monomere zerlegt. Anschließend strömen die Parylene durch die fluidische Verbindung 64 in die Drehtrommel 68, in der sich energetisches Material 12 befindet. Das energetische Material 12 wird durch Drehung der Drehtrommel umgewälzt und bei etwa 20°C mit den Parylenen beschichtet. Restliche Parylene-Monomere werden durch eine zweite fluidische Verbindung **72** aus der Drehtrommel hinausgeleitet und in einer Kältefalle **74** der Parylenenanlage bei etwa -196°C polymerisiert. Die Kältefalle 74 weist hierzu Flüssigstickstoff (LN₂) **76** auf. Anschließend werden die Parylene durch eine Vakuumpumpe **78** der Parylenenanlage 58 aus der Kältefalle 74 hinausgeleitet.

Unter Berücksichtigung der Figuren der Zeichnung betrifft die Erfindung zusammenfassend ein Beschichtungsverfahren eines energetischen Materials 12, insbesondere im Vakuum. Das energetische Material 12 wird durch chemische Gasphasenabscheidung beschichtet. Das Beschichtungsmaterial 16 ist elektrisch leitfähig und/oder hydrophob oder hydrophil. Das energetische Material 16 weist die Gestalt von Körnern und/oder Pellets auf und/oder liegt als Pulver vor. Die Beschichtung erfolgt in einem Plasma. Weiter bevorzugt erfolgt die Beschichtung in Form einer Plasmapolymerisation. Unter energetischen Materialien werden insbesondere Sprengstoffe und pyrotechnische Sätze und Treibladungen verstanden. Dabei ist zu berücksichtigen, dass unter einer Beschichtung nicht nur die Anlagerung einer Schicht, sondern auch die Umwandlung einer Schicht verstanden wird. Beispielsweise erfolgt bei einer Plasmabehandlung von rauchfreiem Pulver mit NF₃ keine NO-Abscheidung, sondern eine Fluraddition der Oberfläche. Ziel der Behandlung ist es, die Abbrandgeschwindigkeit des energetischen Materials zu erhöhen oder zu erniedrigen, die Leitfähigkeit des elektrischen Materials zum Schutz vor elektrischen Entladungen zu erhöhen, zum Schutz vor Korrosion Stickoxide zu minimieren, einen Plagiatschutz zu erzielen und/oder die Schmierung zu verbessern, das energetische Material zum Schutz vor Korrosion zu hydrophobieren oder eine bessere Vermischbarkeit des energetischen Materials mit Wasser durch Hydrophilieren zu erreichen.

## Patentansprüche

1. Beschichtungsverfahren eines energetischen Materials (12), das in Form von Körnern, Pellets und/oder als Pulver ausgebildet ist, mit einem Beschichtungsmaterial (16), **dadurch gekennzeichnet, dass** das Beschichtungsmaterial (16)
a) hydrophob oder hydrophil
und/oder
b) elektrisch leitfähig ist,
wobei die Beschichtung durch eine plasmaunterstützte chemische Gasphasenabscheidung erfolgt, wobei die Beschichtung des energetischen Materials in einer Vakuumkammer (28) erfolgt, die während der Gasphasenabscheidung um eine in horizontaler Richtung verlaufende Drehachse gedreht wird.

2. Beschichtungsverfahren nach Anspruch 1, **dadurch gekennzeichnet, dass** das energetische Material (12) einen Sprengstoff, einen pyrotechnischen Satz und/oder eine Treibladung aufweist.

3. Beschichtungsverfahren nach einem der vorhergehenden Ansprüche, **dadurch gekennzeichnet, dass** das energetische Material (12) eine Explosionswärme von mehr als 2500 kJ/kg, eine Abbrandgeschwindigkeit von mehr als 30 m/s und/oder eine Bleiblockausbauchung von mehr als 30 cm³ aufweist.

4. Beschichtungsverfahren nach einem der vorhergehenden Ansprüche, **dadurch gekennzeichnet, dass** das energetische Material (12) Schwarzpulver, Nitroglycerin und/oder Nitrozellulose aufweist.

5. Beschichtungsverfahren nach einem der vorhergehenden Ansprüche, **dadurch gekennzeichnet, dass** das Beschichtungsmaterial (16) Halogene; Monomere, die zumindest ein Halogen aufweisen; Silizium; Monomere, die Silizium aufweisen; Silazane, insbesondere Hexamethyldisilazan; Siloxane; Silane; Fluor; Kohlenwasserstoff; insbesondere gesättigten und/oder ungesättigten Kohlenwasserstoff; aliphatischen Kohlenwasserstoff; aromatischen Kohlenwasserstoff; Derivate von aliphatischem Kohlenwasserstoff und/oder aromatischem Kohlenwasserstoff, die insbesondere Heteroatome aufweisen; Sauerstoff; leitfähige Polymere; Alkane, insbesondere Fluoralkane; Cycloalkane; Mischungen umfassend Alkane und Halogene, Alkene, Mischungen umfassend Alkene und Halogene; Hexamethyldisiloxan; Fluoracrylate; Octafluorcyclobutan; Ethin; Parylene; Paraffin; Octen; Hexafluorethan; Acrylsäure und/oder Kombinationen der vorgenannten Stoffe aufweist.

6. Beschichtungsverfahren nach einem der vorhergehenden Ansprüche, **dadurch gekennzeichnet, dass** die Beschichtung bei einem Druck von maximal 10 Millibar und/oder einer Temperatur von maximal 130° Celsius erfolgt.

7. Beschichtungsverfahren nach einem der vorhergehenden Ansprüche, **dadurch gekennzeichnet, dass** die Zündung des Plasmas durch eine Elektrode (40) in der Vakuumkammer (28) erfolgt, die insbesondere mit einem elektrischen Isolator (38), vorzugsweise Glas oder Keramik, beschichtet ist.

8. Beschichtungsverfahren nach einem der vorhergehenden Ansprüche, **dadurch gekennzeichnet, dass** die Beschichtung mit einer Dicke von mehr als 0,1 Nanometer, insbesondere einer Dicke von maximal zwei Mikrometern, aufgetragen wird.

## Claims

1. Coating method for energetic material (12), which is in the form of grains, pellets and/or a powder, with a coating material (16), **characterized in that** the coating material (16)
a) is hydrophobic or hydrophilic
and/or
b) is electrically conductive,
wherein the coating is carried out by plasma-enhanced chemical vapor deposition, wherein the energetic material is coated in a vacuum chamber (28) which is rotated about an axis of rotation running in the horizontal direction during vapor deposition.

2. Coating method according to claim 1, **characterized in that** the energetic material (12) comprises an explosive, a pyrotechnic composition and/or a propellant.

3. Coating method according to any of the preceding claims, **characterized in that** the energetic material (12) has an explosion heat of more than 2500 kJ/kg, a burn rate of more than 30 m/s and/or a Trauzl number of more than 30 cm³.

4. Coating method according to any of the preceding claims, **characterized in that** the energetic material (12) comprises black powder, nitroglycerin and/or nitrocellulose.

5. Coating method according to any of the preceding claims, **characterized in that** the coating material (16) contains halogens; monomers containing at least one halogen; silicon; monomers containing silicon; silazanes, in particular hexamethyldisilazane; siloxanes; silanes; fluorine; hydrocarbon; in particular saturated and/or unsaturated hydrocarbon; aliphatic hydrocarbon; aromatic hydrocarbon; derivatives of aliphatic hydrocarbon and/or aromatic hydrocarbon, in particular containing heteroatoms; oxygen; conductive polymers; alkanes, in particular fluoroalkanes; cycloalkanes; mixtures containing alkanes and halogens, alkenes, mixtures containing alkenes and halogens; hexamethyldisiloxane; fluoroacrylates; octafluorocyclobutane; ethine; parylene; paraffin; octene; hexafluoroethane; acrylic acid and/or combinations of the aforementioned substances.

6. Coating method according to any of the preceding claims, **characterized in that** the coating takes place at a pressure of a maximum of 10 millibars and/or a temperature of a maximum of 130° Celsius.

7. Coating method according to any of the preceding claims, **characterized in that** the plasma is ignited by an electrode (40) in the vacuum chamber (28) which is coated in particular with an electrical insulator (38), preferably glass or ceram ics.

8. Coating method according to any of the preceding claims, **characterized in that** the coating is applied with a thickness of more than 0.1 nanometers, in particular a maximum thickness of two micrometers.

## Revendications

1. Procédé de revêtement d'un matériau énergétique (12), réalisé sous forme de grains, de granulés et/ou de poudre, avec un matériau de revêtement (16), **caractérisé en ce que** le matériau de revêtement (16) est
a) hydrophobe ou hydrophile
et/ou
b) électriquement conducteur,
le revêtement intervenant grâce à un dépôt chimique en phase vapeur assisté par plasma, et le revêtement du matériau énergétique intervenant dans une chambre à vide (28) que l'on fait tourner autour d'un axe de rotation s'étendant dans la direction horizontale pendant le dépôt en phase vapeur.

2. Procédé de revêtement selon la revendication 1, **caractérisé en ce que** le matériau énergétique (12) présente un explosif, un ensemble pyrotechnique et/ou une charge propulsive.

3. Procédé de revêtement selon l'une quelconque des revendications précédentes, **caractérisé en ce que** le matériau énergétique (12) présente une chaleur d'explosion supérieure à 2500 kJ/kg, une vitesse de combustion supérieure à 30 m/s et/ou une expansion de bloc de plomb supérieure à 30 cm3.

4. Procédé de revêtement selon l'une quelconque des revendications précédentes, **caractérisé en ce que** le matériau énergétique (12) contient de la poudre noire, de la nitroglycérine et/ou de la nitrocellulose.

5. Procédé de revêtement selon l'une quelconque des revendications précédentes, **caractérisé en ce que** le matériau de revêtement (16) contient des halogènes ; des monomères contenant au moins un halogène ; du silicium ; des monomères contenant du silicium ; des silazanes, en particulier de l'hexaméthyldisilazane ; des siloxanes ; des silanes ; du fluor ; un hydrocarbure ; en particulier un hydrocarbure saturé et/ou insaturé ; un hydrocarbure aliphatique ; un hydrocarbure aromatique ; des dérivés d'hydrocarbure aliphatique et/ou d'hydrocarbure aromatique contenant en particulier des hétéroatomes ; de l'oxygène ; des polymères conducteurs ; des alcanes, en particulier des fluoroalcanes ; des cycloalcanes ; des mélanges comprenant des alcanes et des halogènes ; des alcènes, des mélanges comprenant des alcènes et des halogènes ; de l'hexaméthyldisiloxane ; des fluoroacrylates ; de l'octafluorocyclobutane ; de l'éthine ; du parylène ; de la paraffine ; de l'octène ; de l'hexafluoroéthane ; de l'acide acrylique et/ou des combinaisons des substances mentionnées ci-dessus.

6. Procédé de revêtement selon l'une quelconque des revendications précédentes, **caractérisé en ce que** le revêtement intervient à une pression maximale de 10 millibars et/ou à une température maximale de 130° Celsius.

7. Procédé de revêtement selon l'une quelconque des revendications précédentes, **caractérisé en ce que** l'allumage du plasma intervient dans la chambre à vide (28) grâce à une électrode (40), en particulier revêtue d'un isolant électrique (38), de manière préférée de verre ou de céramique.

8. Procédé de revêtement selon l'une quelconque des revendications précédentes, **caractérisé en ce que** le revêtement est appliqué avec une épaisseur supérieure à 0,1 nanomètre, en particulier avec une épaisseur maximale de deux micromètres.
